Europäisches Patentamt

European Patent Office

Office européen des brevets

(19)

(11) EP 0 905 881 A1

(12) DEMANDE DE BREVET EUROPEEN

(43) Date de publication:
31.03.1999 Bulletin 1999/13

(51) Int Cl.$^6$: H03F 1/02

(21) Numéro de dépôt: 98402321.8

(22) Date de dépôt: 22.09.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 24.09.1997 FR 9711873

(71) Demandeur: STMicroelectronics SA
94250 Gentilly Cedex (FR)

(72) Inventeur: Van Zanten, Francois
38240 Meylan (FR)

(74) Mandataire: Dubois-Chabert, Guy
Société de Protection des Inventions
25, rue de Ponthieu
75008 Paris (FR)

(54) **Amplificateur de courant, en particulier pour ligne téléphonique**

(57) L'invention a pour objet un dispositif amplificateur de courant (2) comportant un premier, un second et un troisième amplificateurs (11, 12, 10) montés en cascade, le courant du troisième amplificateur (10) constituant le courant de sortie ($I_L$) de l'amplificateur de courant (2), le courant du premier amplificateur (11) se déduisant du courant du troisième amplificateur (10) et le courant du second amplificateur (12) fonctionne en redresseur et délivre son courant sur une borne d'alimentation ($V_{CC}$) éventuellement découplée à la masse (condensateur (6)). Il est possible de réaliser un dispositif comportant seulement deux amplificateurs.

FIG. 2

**Description**

Domaine technique et art antérieur

L'invention concerne un amplificateur de courant, en particulier pour une ligne téléphonique.

L'invention s'applique plus particulièrement à la réalisation de la partie d'amplificateur de ligne d'un circuit intégré assurant le couplage entre un MODEM et une ligne téléphonique.

Dans les dispositifs connus de l'art antérieur, on utilise le transformateur de ligne pour assurer l'isolement entre la ligne et le monde extérieur, ce qui est à la fois encombrant et coûteux car le transformateur doit avoir une très grande linéarité et une tension d'isolement de plusieurs milliers de volts.

Une autre solution suivant l'art antérieur consiste à utiliser des optocoupleurs dont la linéarité a été améliorée par des dispositifs électroniques complexes. Ces dispositifs sont coûteux et consomment de l'énergie électrique, laquelle est très limitée sur une ligne téléphonique.

Une autre solution consiste à utiliser un transformateur pour transférer l'alimentation à partir d'une source extérieure. Mais cette solution est coûteuse car elle nécessite d'ajouter un transformateur et un convertisseur continu/continu.

Une autre solution connue de l'art antérieur consiste à alimenter le MODEM directement sur la ligne téléphonique. Cette solution présente les inconvénients suivants :

- la tension d'alimentation varie comme la modulation de la ligne, d'où la nécessité d'avoir une très bonne réjection d'alimentation des parties analogiques alimentées directement par la ligne (convertisseurs A/D et D/A),
- le courant consommé doit être rigoureusement contrôlé pour ne pas perturber ni créer des harmoniques ou du bruit sur la ligne afin que le dispositif anti-écho joue son rôle, ce qui exclut des circuits logiques de type CMOS.

Les deux premières solutions sont basées sur le transfert analogique des données entre la ligne téléphonique et le monde extérieur.

Les deux dernières solutions incorporent les convertisseurs D/A et A/D du côté ligne : le transfert s'effectue sous forme digitale, ce qui permet de s'affranchir des exigences de linéarité de la barrière d'isolation entra la ligne et le monde extérieur. On peut donc utiliser des barrières optiques ou des transformateurs ou encore des condensateurs peu encombrants et bon marché. En revanche, il faut trouver le moyen d'alimenter les convertisseurs à partir de la ligne téléphonique sans perturber celle-ci par des distorsions ou du bruit.

Enfin, les dispositifs de l'art antérieur ne permettent pas une utilisation sur une ligne longue (de plusieurs kilomètres de long, par exemple 4 ou 5 km, ou 8 km), compatible avec des modes de transmission à haut débit (par exemple : V34).

Exposé de l'invention

L'invention propose un amplificateur de courant pour ligne téléphonique, permettant de prélever de l'énergie électrique sur la ligne, en particulier pour alimenter les fonctions logiques et analogiques de traitements des signaux d'émission et de réception d'un MODEM, notamment les convertisseurs D/A et A/D ainsi que les autres fonctions d'un poste téléphonique définies par des normes (caractéristique continue, synthèse d'impédance, antilocal).

L'invention a pour objet un dispositif amplificateur de courant comportant un premier et un second amplificateurs montés en cascade et en suiveur de tension, le courant du second amplificateur se déduisant du courant du premier amplificateur, et ce second amplificateur fonctionnant en redresseur ou étant un amplificateur redresseur.

Dans ce dispositif, le second amplificateur fonctionne en redresseur et le premier amplificateur permet de filtrer les harmoniques que le second amplificateur engendre.

Dans le cas de l'application à une ligne téléphonique, le premier amplificateur a pour source d'alimentation la ligne elle-même et le second, qui fonctionne en redresseur a pour source d'alimentation le premier amplificateur.

Dans le cas où le taux d'harmoniques obtenu n'est pas suffisamment bas pour l'application envisagée, on peut ajouter un troisième amplificateur, également monté en suiveur de tension, et monté de manière à ce que le courant du premier amplificateur provienne de ce troisième amplificateur ou se déduise du courant de ce troisième amplificateur.

Dans le cas de l'application à une ligne téléphonique, le troisième amplificateur a pour source la ligne elle-même, le premier a pour source le troisième amplificateur et le second, qui fonctionne en redresseur, a pour source le premier amplificateur.

Avec un tel montage, un taux d'harmoniques très faible est obtenu, satisfaisant les applications les plus exigeantes.

Des amplificateurs de produit gain x bande meilleure que 10 MHz et de gain en boucle ouverte supérieur à 60 dB permettent d'assurer alors un taux d'harmoniques inférieur à -100 dB sur une ligne à laquelle le dispositif selon l'invention est relié.

De plus, si la tension minimale de fonctionnement de chacun des amplificateurs est inférieure à quelques volts (par exemple : 2V ou 1,8 V), on obtient un dispositif pouvant fonctionner avec une tension de ligne bien plus basse que les dispositifs suivant l'art antérieur.

Selon un mode particulier de réalisation, le second amplificateur dérive son courant de sortie sur une borne d'alimentation par l'intermédiaire d'un transistor MOS, et comporte en outre des moyens pour bloquer ce transistor et pour conférer au second amplificateur un fonctionnement en redresseur, ainsi qu'un amplificateur différentiel dont la sortie commande la grille du transistor MOS, la source de ce dernier étant reliée à une entrée de l'amplificateur différentiel.

En outre, des moyens peuvent être prévus pour polariser le caisson du transistor MOS à sa source quand ses électrodes de source et de drain sont permutées par suite des inversions de polarité dues au fonctionnement en redresseur.

Selon un mode de réalisation, le second amplificateur dérive son courant de sortie sur une borne d'alimentation par l'intermédiaire d'un transistor MOS et comporte :

- un amplificateur différentiel, suivi d'un autre amplificateur différentiel dont la sortie commande la grille du transistor MOS, la source de ce dernier étant reliée à l'entrée de contre-réaction de l'amplificateur différentiel,
- des moyens pour bloquer le transistor MOS et pour conférer au second amplificateur un fonctionnement en redresseur,
- des moyens pour polariser correctement le caisson du transistor MOS quand ses électrodes de source et de drain sont permutées par suite des inversions de polarité dues au fonctionnement en redresseur.

Le premier amplificateur et éventuellement, le troisième amplificateur peuvent comporter un amplificateur différentiel, un transistor monté en émetteur commun, et un dispositif suiveur de tension.

L'invention s'applique notamment à la réalisation d'une installation téléphonique, un dispositif tel que décrit ci-dessus étant relié à une ligne téléphonique.

Dans ce cas, le dispositif ou circuit selon l'invention comporte, selon un mode particulier de réalisation, une borne d'entrée E recevant un courant d'entrée $I_E$, une borne de sortie S absorbant le courant $I_L$ d'une ligne téléphonique, et il délivre, sur une troisième borne, une tension $V_{CC}$ et un courant $I_{CC}$ d'alimentation. Ce circuit incorpore en outre un premier et un second amplificateurs montés en cascade et en suiveurs de tension, chaque amplificateur comportant une résistance à l'entrée ($R'_1$, $R'_2$) et une résistance à la sortie ($R_1$, $R_2$), les résistances $R'_1$ et $R'_2$ étant montées en série et parcourues par le courant d'entrée $I_E$. Les gains en courant de chacun des amplificateurs sont déterminés par les rapports $R'_1/R_1$ et $R'_2/R_2$, et le courant du second amplificateur vient se déduire du courant de sortie du premier amplificateur. Le courant de sortie $I_L$ est maintenu proportionnel au courant d'entrée $I_E$ (il est égal au rapport $R'_1/R_1$), et le second amplificateur fonctionne comme un redresseur. Son courant $I_{CC}$ est borné par la fraction du courant de sortie $I_L$, déterminée par les rapports de résistances $R'_1/R_1$ et $R'_2/R_2$.

Le dispositif, ou circuit, peut en outre incorporer un troisième amplificateur monté également en suiveur de tension et en cascade avec les deux premiers amplificateurs, cet amplificateur comportant une résistance à l'entrée $R'_0$ et une résistance à la sortie $R_0$, les résistances $R'_0$, $R'_1$ et $R'_2$ étant montées en série et parcourues par le courant d'entrée $I_E$, le gain en courant de ce troisième amplificateur étant déterminé par le rapport $R'_0/R_0$ et les courants des premier et second amplificateurs venant se déduire du courant de ce troisième amplificateur. Le courant de sortie $I_L$ est encore maintenu proportionnel au courant d'entrée $I_E$ (rapport $R'_0/R_0$).

L'invention a également pour objet un circuit intégré comportant un dispositif tel que décrit ci-dessus.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1 est une représentation schématique d'un dispositif selon l'invention.
- la figure 2 représente schématiquement des éléments d'un dispositif selon l'invention,
- la figure 3 représente une réalisation d'un dispositif selon l'invention,
- la figure 4 représente une autre réalisation d'un dispositif selon l'invention.

Description détaillée de modes de réalisation de l'invention

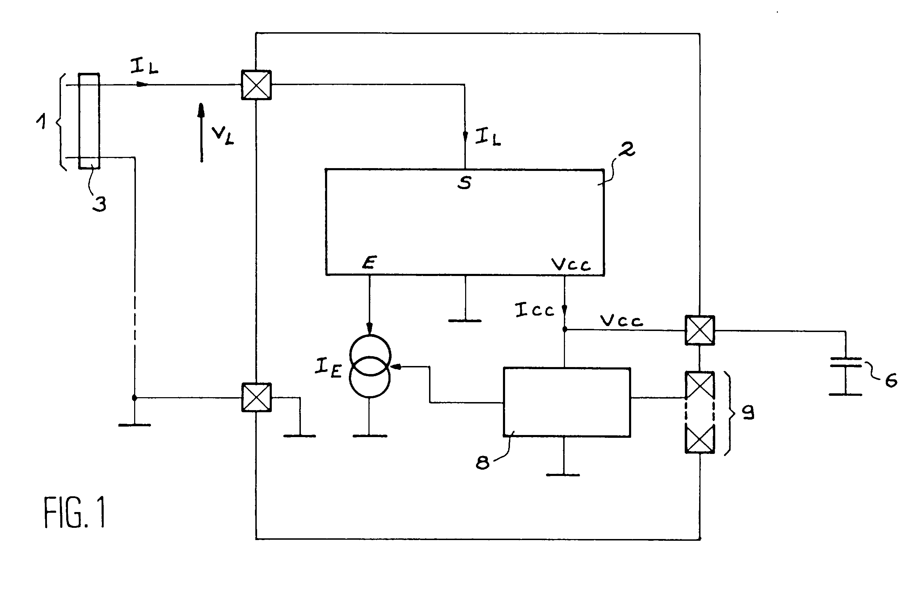

La figure 1 permet de comprendre le rôle joué par l'invention dans le cas d'une ligne téléphonique.

Cette figure représente un circuit intégré comportant la partie 2, objet de l'invention, et la partie 8, fournissant le signal de commande de la partie 2.

L'amplificateur de ligne, objet de l'invention, est constitué de l'amplificateur de courant 2 recevant sur son entrée E un courant $I_E$ et délivrant sur sa sortie S le courant $I_L$ de la ligne téléphonique 1. La tension $V_L$ de la ligne, est fixée ici positive par rapport à la masse. Le courant $I_L$ peut être la superposition d'un courant continu, typiquement compris entre 10 mA et 100 mA, et d'un courant alternatif représentant un signal à recevoir et/ou à transmettre. Le gain $I_L/I_E$ de cet amplificateur est fixé par exemple à 40. Le courant $I_E$, qui détermine $I_L$, est par exemple une somme pondérée de courants correspondant à la modulation d'émission/réception, à la synthèse d'impédance, au duplexeur et à la caractéristique continue. Toutes ces composantes peuvent varier en fonction des normes à respecter. La génération de ce courant est réalisée par des moyens 8, comportant des convertisseurs D/A et A/D. Ces moyens 8 sont eux-mêmes reliés à diverses entrées-sorties 9 pour diverses fonctions. Ces entrées-sorties 9 sont digitales, permettant ainsi une barrière d'isolation de faible coût.

La référence 3 désigne un ensemble de composants pouvant être présents entre la ligne 1 et un utilisateur.

L'amplificateur de courant 2 comporte une seconde sortie de tension continue $V_{CC}$ destinée à fournir le courant $I_{CC}$ d'alimentation du circuit intégré, notamment de la partie 8. Cette tension d'alimentation peut être découplée par un condensateur 6 pour réduire l'ondulation. Ainsi, le condensateur 6 se charge sur les crêtes positives de la tension ligne et se décharge pendant les crêtes négatives, assurant alors le courant d'alimentation $I_{CC}$.

La charge pulsée du condensateur 6 pendant les crêtes positives produit des variations de courant très riches en harmoniques qui ne doivent pas se répercuter sur la ligne 1.

L'amplificateur de ligne selon l'invention permet d'éviter ces répercussions. En particulier, il permet d'éviter que les bruits créés par les consommateurs sur l'alimentation $V_{CC}$, notamment les bruits de commutation, ne se transmettent sur la ligne 1.

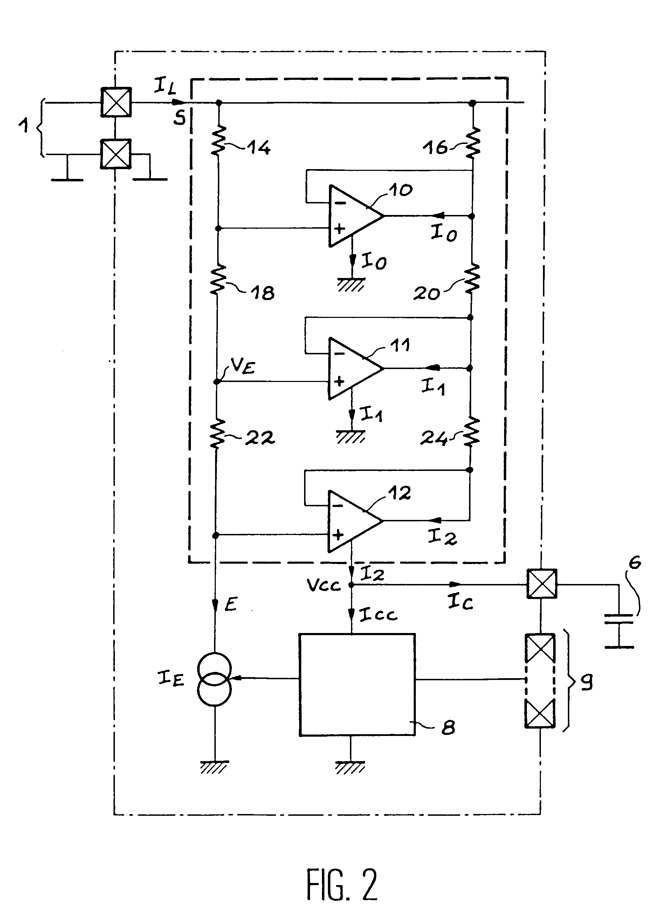

Comme illustré sur la figure 2, l'amplificateur de courant selon l'invention peut comporter trois amplificateurs 10, 11, 12 montés en cascade, chacun étant lui-même monté en suiveur de tension. Le courant de sortie de l'amplificateur 11 vient en déduction de celui de l'amplificateur 10 et le courant de sortie de l'amplificateur 12 vient en déduction de celui de amplificateur 11. Le courant de sortie de l'amplificateur 10 vient, lui, de la ligne 1. Un autre mode de réalisation, détaillé plus loin, ne met en oeuvre que deux amplificateurs.

Chaque amplificateur comporte une résistance d'entrée 14 ($R'_0$), 18 ($R'_1$), 22 ($R'_2$) parcourue par un courant $I_E$ et une résistance de sortie 16 ($R_0$), 20 ($R_1$), 24 ($R_2$). Les résistances 14 et 16 sont connectées à la sortie S. Pour l'amplificateur 10 (respectivement 11, 12) le rapport $R'_0/R_0$ de la valeur de la résistance 14 à celle de la résistance 16 (respectivement : de la valeur de la résistance 18 à celle de la résistance 20 ($R'_1/R_1$) ; de la valeur de la résistance 22 à celle de la résistance 24 ($R'_2/R_2$)) est de $K_0$ (respectivement : $K_1$, $K_2$). Ainsi, les gains en courant de chacun des amplificateurs sont, respectivement, $K_0$, $K_1$, $K_2$.

L'amplificateur 10 absorbe et dérive à la masse l'excès de son courant de sortie sur le courant de sortie de l'amplificateur 11. De même, l'amplificateur 11 absorbe et dérive vers la masse l'excès de son courant de sortie sur le courant de sortie de l'amplificateur 12 alors que ce dernier délivre la totalité de son courant de sortie sur la borne $V_{CC}$.

Le gain en courant du circuit amplificateur de courant reste constant et déterminé par le gain en courant de l'amplificateur 10 (en fait : égal au gain en courant de l'amplificateur 10).

L'amplificateur 12 a un fonctionnement intermittent (il est bloqué, puis conducteur), contrairement aux amplificateurs 10 et 11 dont le fonctionnement est permanent. En effet, si la tension d'entrée $V_E$ de l'amplificateur 12 est supérieure à la tension $V_{CC}$ sur sa borne de sortie, alors celui-ci conduit bien un courant $I_2=K_2I_E$. Le courant $I_2$ vient charger le condensateur 6, par le courant $I_C$, et fournit le courant $I_{CC}$ aux moyens 8 de génération de signal : $I_2=I_C+I_{CC}$. Lorsque la tension d'entrée $V_E$ est inférieure à $V_{CC}$, l'amplificateur 12 se bloque.

Par conséquent, le courant $I_2$ commute entre les valeurs $K_2I_E$ et 0, suivant que $V_E$ est supérieur ou inférieur à $V_{CC}$.

La tension d'entrée $V_E$ de l'amplificateur 12 suit la tension $V_L$ de ligne 1 à la chute ohmique $I_E$ ($K_0R_0+K_1R_1+K_2R_2$) près, soit à quelques centaines de millivolts près.

L'amplificateur 12 fonctionne donc en redresseur : il fournit du courant sur les crêtes positives et est bloqué sur les crêtes négatives, avec un courant borné par $K_2I_E$.

Le courant maximal de l'amplificateur 12 est proportionnel au courant $I_E$, donc à $I_L$, c'est-à-dire aux courants aux bornes d'entrée E et de sortie S. Les amplificateurs 10 et 11 permettent de filtrer les harmoniques engendrées par l'amplificateur-redresseur 12.

L'amplificateur 11 impose le courant $K_1I_E$ dans la résistance 20. Son courant $I_1$ dérivé à la masse, est donc égal à :

$$I_1 = K_1 I_E - I_2.$$

Il s'agit donc d'un courant pulsé, compris entre $K_1 I_E$ (pour $I_2=0$) et $(K_1-K_2) I_E$ (pour : $I_2=K_2 I_E$). Ainsi, les harmoniques engendrées par l'amplificateur 12 sont dérivées à la masse par l'amplificateur 11 (du fait du montage de ce dernier en suiveur), et le courant renvoyé sur la ligne est $K_1 I_E$, image du courant d'entrée $I_E$.

De préférence, on choisit $K_1-K_2$ suffisamment élevé de manière à ce que le courant $I_1$ de l'amplificateur 11 soit suffisant pour assurer la stabilité et le produit gain x bande désiré ; cependant $K_1-K_2$ n'est pas trop élevé, pour rendre maximale la fraction du courant de ligne délivré à l'alimentation $V_{CC}$. Un ordre de grandeur pour le courant $I_1$ minimum de l'amplificateur 11 est par exemple 1/10 du courant de ligne, ce qui correspond, pour un courant de ligne minimum d'environ 6 mA, à 600 µA dans l'amplificateur 11. Ceci permet d'obtenir le produit gain x bande désiré.

Le produit gain x bande de l'amplificateur 11 étant forcément limité, il reste dans la résistance 20 un résidu correspondant à la différenciation du courant pulsé de l'amplificateur 11. Dans certaines applications, ce résidu ne permet pas d'obtenir un taux d'harmoniques suffisant : on monte alors le troisième amplificateur, 10, en cascade avec l'amplificateur 11.

L'amplificateur 10 impose le courant $K_0 I_E$ dans la résistance 16. Son courant $I_0$, dérivé à la masse, est donc égal à :

$$I_0 = K_0 I_E - K_1 I_E = (K_0-K_1) I_E.$$

Ce courant est constant et ne comporte plus de commutation ; à ceci près qu'il y reste le résidu, très faible, de la différentiation due à l'amplificateur 11 : ce résidu est alors dérivé à la masse de l'amplificateur 10 (du fait du montage de ce dernier en suiveur de tension), et n'est pas envoyé dans la résistance 16, donc sur la ligne.

Avec un tel montage, on obtient un taux d'harmoniques très satisfaisant.

On peut utiliser, pour réaliser ce montage, des amplificateurs ayant par exemple un produit gain x bande supérieur à 10 MHz, et un gain en boucle ouverte supérieur à 60dB. Un tel montage permet d'assurer la linéarité du signal sur la ligne 1. On peut ainsi obtenir un taux d'harmoniques inférieur à -100dB sur la ligne.

Les différents courants significatifs sont indexés sur le courant de ligne $I_L$ par les rapports de résistances $K_0$, $K_1$, $K_2$, qui peuvent être très précis en réalisation circuit intégré.

On a les formules suivantes :

- gain de l'amplificateur de courant : $I_L/I_E = K_0+1 = 40$,
- courant absorbé par l'amplificateur 10 : $I_L(K_0-K_1)/(K_0+1)$ (ce courant est positif si $K_0>K_1$),
- courant maximal de l'amplificateur 11 : $I_L K_1/(K_0+1)$,
- courant minimal de l'amplificateur 11 : $I_L(K_1-K_2)/(K_0+1)$ (ce courant est positif si $K_1>K_2$),
- courant maximal absorbé par l'amplificateur 12 : $I_L K_2/(K_0+1)$,
- courant minimal absorbé par l'amplificateur 12 : 0

Avec les valeurs suivantes :
$R_0 = R_1 = R_2 = 10\Omega$, $K_0 = 39$, $K_1 = 36$, $K_2 = 32$, on obtient : $I_L/I_E=40$, $I_L(K_0-K_1)/(K_0+1)=1/10 I_L$, $I_L K_1/(K_0+1)=9/10 I_L$, $I_L(K_1-K_2)/(K_0+1)=1/10 I_L$, $I_L K_2/(K_0+1)=8/10 I_L$ (80% du courant de ligne est affecté à l'alimentation $V_{CC}$).

Un montage avec seulement deux amplificateurs, l'amplificateur 12 et l'amplificateur 11, permet d'obtenir un taux d'harmoniques voisin de -80dB, ce qui est déjà appréciable et convient largement à des applications de type poste téléphonique. Dans un tel montage, les deux amplificateurs 11, 12 sont encore montés en cascade, chacun étant lui-même monté en suiveur de tension. Le courant de sortie de l'amplificateur 12 vient en déduction de celui de l'amplificateur 11, et le courant de sortie de l'amplificateur 11 vient de la ligne 1. L'amplificateur 11 comporte toujours une résistance d'entrée 18 ($R'_1$) et une résistance de sortie 20 ($R_1$), connectées à la sortie S. L'amplificateur 12 comporte une résistance d'entrée 22 ($R'_2$) et une résistance de sortie 24 ($R_2$). Le gain en courant $K_1$, $K_2$ de chacun de ces amplificateurs est déterminé, respectivement, par les rapports $R'_1/R_1$ et $R'_2/R_2$. L'amplificateur 11 absorbe et dérive vers la masse l'excès de son courant de sortie sur le courant de sortie de l'amplificateur 12 alors que ce dernier délivre la totalité de son courant de sortie sur la borne $V_{CC}$. Le gain en courant du circuit amplificateur de courant reste constant, et est déterminé par le gain en courant de l'amplificateur 11 (pratiquement, ici : égal à celui-ci). L'amplificateur 12 a toujours un fonctionnement intermittent (il fonctionne en redresseur), tandis que l'amplificateur 11 a un fonctionnement permanent.

Là encore, les différents courants significatifs sont indexés sur le courant de ligne $I_L$ dans les rapports de résistance $K_1$, $K_2$ qui peuvent être très précis en réalisation de circuits intégrés.

On a les formules suivantes :

- gain en courant de l'amplificateur 11 : $I_L/I_E = K_1+1$,
- courant minimum absorbé par l'amplificateur 11 : $I_L(K_1-K_2)/(K_1+1)$,
- courant maximum absorbé par l'amplificateur 11 : $I_L K_1/(K_1+1)$,
- courant maximum de l'amplificateur 12 : $I_L K_2/(K_1+1)$,
- courant minimum de l'amplificateur 12 : 0A

Selon un exemple : $K_1=39$, $K_2=35$, $R_1=R_2=10\Omega$, et on obtient : $I_L/I_L=40$, $I_L(K_1-K_2)/(K_1+1)=1/10I_L$, $I_L K_1/(K_1+1)$ $=39/40I_L$, $I_L K_2/(K_1+1) \approx 0,875I_L$ (87,5% du courant de ligne est donc affecté à l'alimentation $V_{CC}$).

Un tel montage à deux amplificateurs est cependant insuffisant pour des applications MODEM de type V34, où le taux d'harmoniques doit être inférieur à -80dB (garanti au pire des cas), ou encore pour des applications de type Interface U, pour lesquelles on peut admettre des distorsions plus élevées, mais où la bande passante est aussi plus élevée. On a alors recours aux trois amplificateurs 10, 11, 12 montés et fonctionnant de la manière décrite ci-dessus.

Les amplificateurs, utilisés pour réaliser le montage suivant l'invention ci-dessus décrite, ont par exemple des produits gain x bande $\geq$10 MHz et des gains en boucle ouverte $\geq$60dB, ce qui ne présente pas de difficulté de réalisation particulière.

Ces amplificateurs ont de préférence, en outre, une consommation propre très faible pour ne pas prélever du courant de ligne aux dépens de l'alimentation $V_{CC}$, $I_{CC}$ et, par ailleurs, une tension de déchet aussi faible que possible pour permettre le fonctionnement à des tensions de ligne les plus basses possibles.

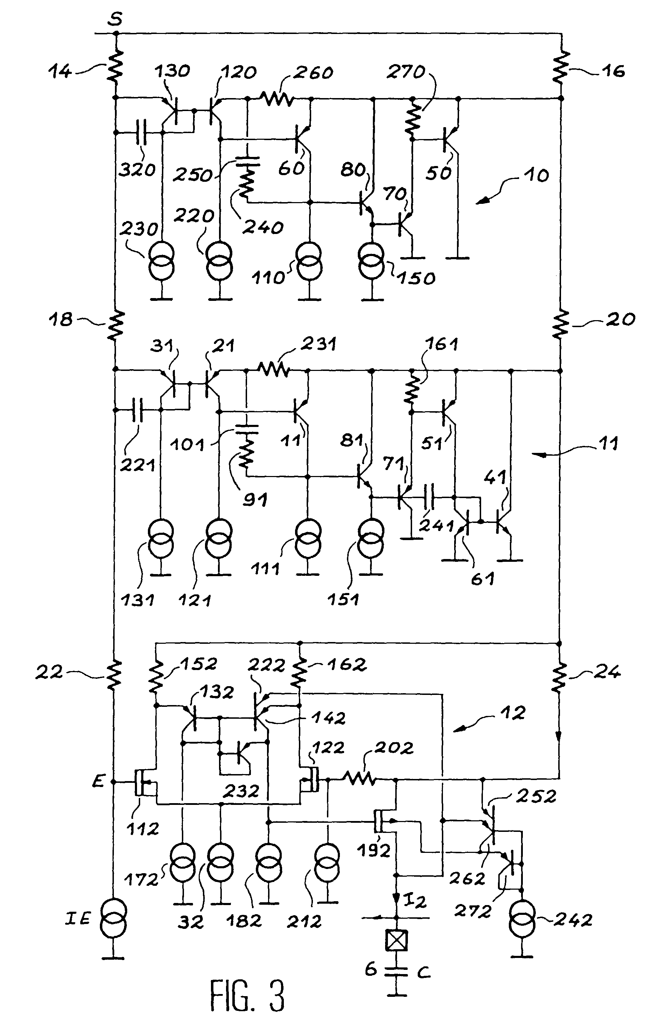

L'invention propose ci-dessous (figure 3) un mode de réalisation de ces amplificateurs permettant d'obtenir une consommation propre de l'ordre de quelques centaines de $\mu$A pour les amplificateurs $A_0$, $A_1$, $A_2$ et une tension de déchet, par rapport à la masse, inférieure à 2V.

La figure 3 donne une représentation détaillée d'un mode de réalisation du montage précédent, et en particulier de chacun des amplificateurs. Les amplificateurs 10 et 11 sont montés en suiveurs de tension sur les résistances 16 et 20, ce qui permet de réaliser les sources de courant asservies au courant d'entrée $I_E$. La chute minimale de tension totale entre leur alimentation positive et la masse est de l'ordre de 1,8V. Plus cette tension minimale de fonctionnement est basse, plus longue est la ligne sur laquelle le circuit peut assurer sa fonction.

Avec ces caractéristiques, on obtient un montage présentant une très bonne linéarité, c'est-à-dire dans lequel les amplificateurs 10 et 11 peuvent filtrer les harmoniques engendrées par l'amplificateur-redresseur 12, mais également un montage permettant d'utiliser une tension de ligne la plus basse possible.

Dans le mode de réalisation de la figure 3, l'amplificateur-redresseur 12 comporte un amplificateur différentiel à MOS N 112-122 (avec, par exemple, $W/L=100\mu m/2\mu m$). Les sources des transistors 112 et 122 sont couplées par une source de courant 32, tandis que les drains de ces mêmes transistors sont couplés à un amplificateur différentiel PNP 132-142 par des résistances 152 et 162. L'amplificateur différentiel 132-142 est ainsi commandé par les émetteurs, et le signal différentiel est transformé en signal simple, sur le collecteur du transistor 142, grâce au montage en diode du transistor 132. L'amplificateur différentiel 132-142 est polarisé par deux sources de courant 172 et 182 égales. Le signal est repris par la grille du transistor MOS P 192 de grande dimension dont la source, chargée par la résistance 24, constitue la sortie. Cette sortie suit la tension d'entrée E (tension de grille du transistor 112) par le rebouclage sur la grille du transistor 122, lorsque le transistor 232 est conducteur. Le courant $I_2$ du transistor 192 alimente alors, par le drain, la borne $V_{CC}$.

La résistance 202 et la source de courant 212 permettent de compenser les tensions de décalage dues aux courants d'entrées, non nuls, des amplificateurs 10 et 11.

Quand la tension $V_E$ devient inférieure à la tension $V_{CC}$, sur les crêtes négatives de la tension ligne, on assure le blocage du transistor 192, mais on assure aussi correctement sa polarisation de caisson car la source et le drain se sont échangés. Le blocage du transistor 192 est réalisé par le transistor PNP 222, qui vient bloquer les transistors 132 et 142 : la grille du transistor 192 est, ainsi, polarisée à $V_{CC}$ (à sa tension de saturation près). Le transistor PNP 232, monté en diode, a pour rôle de limiter le degré de saturation du transistor 222. Ceci limite son courant d'émetteur, et permet d'éviter de consommer sur la tension $V_{CC}$. La polarisation de caisson du transistor 192 est réalisée par la source de courant 242 et par les deux transistors PNP 252 et 262, dont les émetteurs sont connectés aux électrodes de drain et de source du transistor 192 et dont les collecteurs sont connectés au caisson du transistor 192. Ainsi, des deux transistors 262 et 252, c'est celui qui aura l'émetteur à la tension la plus haute qui sera polarisé par le courant de base de la source 242, polarisant le caisson du transistor 192 à cette même tension (à sa tension de saturation près). Le transistor PNP 272, monté en diode, limite le degré de saturation des transistors 252 ou 262, limitant ainsi les courants inverses d'émetteurs.

Pour tenir des tensions base/émetteur inverses élevées, les PNP sont de préférence de type latéral.

Le dimensionnement du transistor 192 (par exemple : $W/L=1000\mu m/2\mu m$) est choisi suffisant pour assurer le courant moyen $I_{CC}$ avec la plus basse tension ligne, soit par exemple 3,5V aux bornes du circuit.

A titre d'exemple, on peut prendre les caractéristiques suivantes :

| $I_{172}=1\mu A$ | $R_{152}=100k\Omega=R_{162}$ | $R_{202}=1160\ \Omega$ |
|---|---|---|
| $I_{32}=2\mu A$ | $I_{242}=1\mu A$ | $I_{212}=30\mu A$ |

L'amplificateur 11 est constitué de l'amplificateur différentiel PNP 31-21 à entrées sur les émetteurs. Il est polarisé par les sources de courant égales 131 et 121, et est suivi du transistor PNP 141 monté en émetteur commun et polarisé par la source de courant 111. Ces deux étages assurent le gain en tension. Le gain en courant est donné par le suiveur de tension constitué par les transistors 81, 71, 51, 61, 41, ce qui permet d'absorber les 100 mA maximum de courant de ligne. Ce suiveur de tension est constitué des trois transistors 81, 71, 51 montés à émetteur suiveur. Le transistor 51 a son courant amplifié par le miroir NPN (de gain 100) constitué des transistors 61, 41. L'entrée sur l'émetteur du transistor 31 consomme le courant fourni par la source 131, ce qui crée une chute ohmique dans les résistances d'entrées 14 et 18. Ces chutes sont compensées par une chute identique dans la résistance 231 ($R_{231}=2R_0$ $(K_0+1)+K_1R_1$). Le réseau RC, constitué par la résistance 91 et la capacité 101, permet d'assurer la stabilité de la boucle de contre-réaction. La capacité 221 sert à court-circuiter, en hautes fréquences, la diode 31. La capacité 241 stabilise la boucle locale du suiveur amplificateur de courant.

On peut remarquer que la tension maximale insérée par cet amplificateur est constitué par l'empilement de deux tensions directes base/émetteur (celles des transistors 51 et 71) et de la tension de déchet de la source de courant 151 (qui peut être inférieure à 0,4 V), soit une tension de déchet totale de l'ordre de 1,8V.

A titre d'exemple, on peut prendre les caractéristiques suivantes :

| $I_{131}=I_{121}=30\mu A$ | $I_{151}=15\mu A$ |
|---|---|
| $I_{111}=60\mu A$ | $C_{221}=5pF=C_{241}$ |
| $C_{101}=4,2pF$ | $R_{231}=1160\Omega$ |
| $R_{91}=300\Omega$ | $R_{161}=20k\Omega$ |

L'amplificateur 10 est identique à l'amplificateur 11 à l'exception du suiveur amplificateur de courant qui ne comporte pas le miroir de courant NPN 61, 41 (de gain 100). Le courant de l'amplificateur 10 n'est en effet qu'une fraction du courant de ligne $I_L$ (1/10 dans l'exemple déjà donné ci-dessus). L'entrée sur l'émetteur du transistor 130 consomme le courant fourni par la source 230, ce qui crée une chute ohmique dans la résistance d'entrée 14. Cette chute est compensée par une chute identique dans la résistance 260 ($R_{260}=2R_0(K_0+1)$).

A titre d'exemple on peut prendre les caractéristiques suivantes :

| $I_{230}=I_{220}=30\mu A$ | $C_{250}=2pF$ |
|---|---|
| $I_{150}=15\mu A$ | $R_{260}=800\Omega$ |
| $I_{110}=60\mu A$ | $R_{270}=20k\Omega$ |
| $R_{240}=330\Omega$ | $C_{320}=5pF$ |

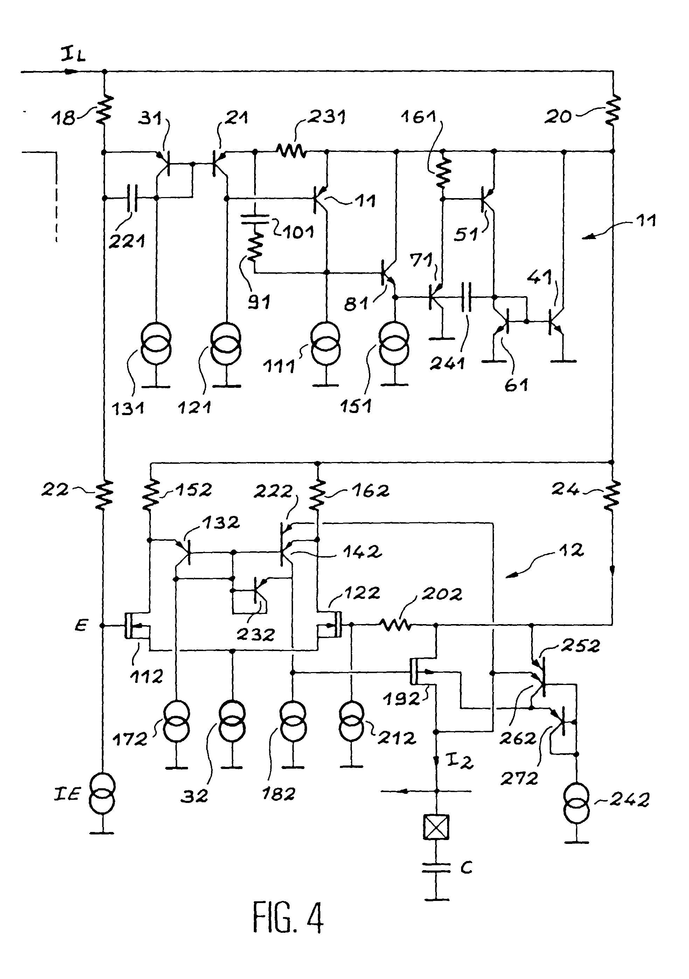

Le mode de réalisation de la figure 4 correspond au cas où seuls deux étages sont montés en cascade : il s'agit ici des amplificateurs 11 et 12, l'amplificateur 10 étant supprimé. Ce montage est suffisant lorsque des taux de distorsion moins contraignants sont imposés. Par exemple, avec les caractéristiques données, on obtient, dans le schéma de la figure 4, un taux de distorsion de l'ordre de -78dB (largement suffisant pour des applications sans les fonctions MODEM), tandis que l'étage supplémentaire 10 (schéma de la figure 3) permet d'atteindre un taux de distorsion meilleur que -100dB.

Les références numérique de la figure 4, identiques à celles de la figure 3, désignent des éléments identiques, ayant les mêmes caractéristiques que celles déjà données ci-dessus.

Dans les deux modes de réalisation exposés ci-dessus (en liaison avec les figures 3 et 4), et dans le cas d'une faible tension continue de ligne, correspondant par exemple à 3,5V aux bornes du circuit intégré, à laquelle peut se superposer une modulation, par exemple une modulation V34 dont la valeur crête peut atteindre 1,1V, la tension aux bornes du circuit intégré se réduit à une valeur faible, par exemple à 2,4V, sur les crêtes négatives. Mais, suivant l'invention, la tension d'alimentation $V_{CC}$ reste proche de la valeur moyenne de la tension ligne $V_L$ (par exemple : 3,5V), ce qui rend beaucoup plus facile le fonctionnement des moyens 8 (voir figure 1) fournissant le signal du circuit intégré, alimentés par $V_{CC}$. On peut même envisager le fonctionnement, par exemple en mode V34, avec des tensions aux bornes du circuit intégré encore plus basses que 3,5V. L'aptitude du circuit selon l'invention à fonctionner à tension basse le rend compatible avec une utilisation sur des lignes de grande longueur (comprise par exemple entre 5 et 8 Km).

**Revendications**

1. Dispositif amplificateur de courant (2) comportant un premier et un second amplificateurs (11, 12) montés en cascade et en suiveur de tension, les deux amplificateurs étant montés de manière à ce que le courant du second amplificateur (12) se déduise du courant du premier amplificateur (11), et ce second amplificateur fonctionnant en redresseur.

2. Dispositif amplificateur selon la revendication 1, comportant un troisième amplificateur (10), également monté en suiveur de tension, le courant du premier amplificateur se déduisant du courant de ce troisième amplificateur.

3. Dispositif amplificateur selon la revendication 1 ou 2, chacun des premier et second amplificateurs comportant une résistance à l'entrée $R'_1$, $R'_2$ (18, 22) et une résistance à la sortie $R_1$, $R_2$ (20, 24), les résistances $R'_1$ et $R'_2$ étant montées en série, ainsi que les résistances $R_1$ et $R_2$, les gains en courant des premier et second amplificateurs étant déterminés, respectivement par les rapports $R'_1/R_1$ et $R'_2/R_2$.

4. Dispositif selon la revendication 3, comportant une borne d'entrée (E) et une borne de sortie (S), les résistances $R'_1$, $R_1$ d'entrée et de sortie (18, 20) du premier amplificateur (11) étant reliées à la borne de sortie (S) du dispositif.

5. Dispositif selon l'une des revendications 3 ou 4, le rapport $R'_1/R_1$ des résistances de sortie (20) et d'entrée (18) du premier amplificateur déterminant le gain en courant du dispositif.

6. Dispositif selon la revendication 2, le troisième amplificateur comportant une résistance à l'entrée $R'_0$ (14) et une résistance à la sortie $R_0$ (16), le gain en courant de ce troisième amplificateur étant déterminé par le rapport $R'_0/R_0$.

7. Dispositif selon la revendication 2, comportant une borne d'entrée et une borne de sortie (S), les résistances $R'_0$, $R_0$ d'entrée et de sortie (14, 16) du troisième amplificateur (10) étant reliées à la borne de sortie du dispositif.

8. Dispositif selon l'une des revendications 6 ou 7, le rapport $R'_0/R_0$ des résistances de sortie (20) et d'entrée (18) du troisième amplificateur déterminant le gain en courant du dispositif.

9. Dispositif amplificateur de courant comportant un premier et un second amplificateurs (11, 12) de courant montés en cascade, chacun étant monté en suiveur de tension, chaque amplificateur étant muni d'une résistance d'entrée $R'_1$, $R'_2$ (18, 22) et d'une résistance de sortie $R_1$, $R_2$ (20, 24), les résistances d'entrée étant montées en série, les résistances de sortie étant montées en série, les gain en courant des premier et second amplificateurs étant déterminés par les rapports $R'_1/R_1$ et $R'_2/R_2$, les premier et second amplificateurs étant montés de manière à ce que le courant du second, circulant dans sa résistance de sortie (24), se déduise du courant du premier amplificateur, circulant dans sa résistance de sortie (20), le second amplificateur étant un amplificateur redresseur, le gain en courant du dispositif étant déterminé par le gain en courant du premier amplificateur (11).

10. Dispositif amplificateur de courant comportant un premier, un second et un troisième amplificateurs (10, 11, 12) de courant montés en cascade, chacun étant monté en suiveur de tension, chaque amplificateur étant muni d'une résistance d'entrée $R'_1$, $R'_2$, $R'_0$ (14, 18, 22) et d'une résistance de sortie $R_1$, $R_2$, $R_0$ (10, 20, 24), les résistances d'entrée étant montées en série, les résistances de sortie étant montées en série, les gain en courant des premier, second et troisième amplificateurs étant déterminés par les rapports $R'_1/R_1$, $R'_2/R_2$ et $R'_0/R_0$, les trois amplificateurs étant montés de manière à ce que le courant du second amplificateur (12) circulant dans sa résistance de sortie (24) se déduise du courant circulant dans la résistance de sortie (20) du premier amplificateur (11) et de manière à ce que le courant circulant dans la résistance de sortie (20) du premier amplificateur (11) se déduise du courant circulant dans la résistance de sortie (16) du troisième amplificateur (10), le second amplificateur étant un amplificateur redresseur, le gain en courant du dispositif étant déterminé par le gain en courant du troisième amplificateur (10).

11. Dispositif selon l'une des revendications 1 à 10, chaque amplificateur ayant un produit gain x bande supérieur à 10 MHz et un gain en boucle ouverte supérieur à 60 dB.

12. Dispositif selon l'une des revendications 1 à 11, chaque amplificateur ayant une tension minimale de fonctionnement de quelques volts.

13. Dispositif selon l'une des revendications 1 à 12, chaque amplificateur ayant une tension minimale de fonctionnement comprise entre 1,5V et 4V.

14. Dispositif selon l'une des revendications 1 à 13, chaque amplificateur ayant une tension minimale de fonctionnement comprise entre 2V et 3V.

15. Dispositif selon l'une des revendications 1 à 14, le second amplificateur (12) dérivant son courant de sortie sur une borne d'alimentation ($V_{CC}$) par l'intermédiaire d'un transistor MOS (192), et comportant en outre des moyens (132, 142, 222) pour bloquer ce transistor et pour conférer au second amplificateur un fonctionnement en redresseur, ainsi qu'un amplificateur différentiel (112, 122) dont la sortie commande la grille du transistor MOS (192), la source de ce dernier étant reliée à une entrée de l'amplificateur différentiel (112, 122).

16. Dispositif selon la revendication 15 comportant en outre des moyens (252, 262, 272, 242) pour polariser le caisson du transistor MOS (192) à sa source quand ses électrodes de source et de drain sont permutées par suite des inversions de polarité dues au fonctionnement en redresseur.

17. Dispositif selon l'une des revendications 1 à 14, le second amplificateur (12) dérivant son courant de sortie sur une borne d'alimentation $V_{CC}$ par l'intermédiaire d'un transistor MOS (192) et comportant :

- un amplificateur différentiel (112, 122), suivi d'un autre amplificateur différentiel (132, 142, 172, 182) dont la sortie commande la grille du transistor MOS (192), la source de ce dernier étant reliée à l'entrée de contre-réaction de l'amplificateur différentiel (112, 122, 32),
- des moyens (132, 242, 222) pour bloquer le transistor MOS (192) et pour conférer au second amplificateur (12) un fonctionnement en redresseur,
- des moyens (252, 262, 272, 242) pour polariser correctement le caisson du transistor MOS (192) quand ses électrodes de source et de drain sont permutées par suite des inversions de polarité dues au fonctionnement en redresseur.

18. Dispositif selon l'une des revendications 1 à 17, le premier amplificateur (11) et éventuellement, le troisième amplificateur (10) comportant un amplificateur différentiel (21, 31, 120, 130), un transistor (141, 60) monté en émetteur commun, et un dispositif suiveur de tension (41, 51, 61, 71, 81 ; 50, 70, 80).

19. Installation de ligne téléphonique comportant une ligne (1) et un dispositif amplificateur selon l'une des revendications 1 à 18.

20. Installation selon la revendication 19, le dispositif amplificateur étant relié à un condensateur (6) et à des moyens (8) pour engendrer un courant signal ($I_E$).

21. Circuit intégré comportant un dispositif suivant l'une des revendications 1 à 18.

FIG. 1

FIG. 2

FIG. 3

FIG. 4

EP 0 905 881 A1

<table>
<tr><td rowspan="2">Office européen<br>des brevets</td><td rowspan="2">**RAPPORT DE RECHERCHE EUROPEENNE**</td><td>Numéro de la demande</td></tr>
<tr><td>EP 98 40 2321</td></tr>
</table>

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 3 999 139 A (FENNELL ROBERT D) 21 décembre 1976 * abrégé; figures 1-3 * --- | 1,9,10 | H03F1/02 |
| A | US 5 440 261 A (RYDEL CHARLES) 8 août 1995 * abrégé; figures 1-4 * --- | 1,9,10 | |
| A | US 5 450 038 A (RYDEL CHARLES) 12 septembre 1995 --- | | |
| A | US 5 459 434 A (LIGER RENE ET AL) 17 octobre 1995 ----- | | |

DOMAINES TECHNIQUES RECHERCHES (Int.Cl.6)

H03F

Le présent rapport a été établi pour toutes les revendications

| Lieu de la recherche | Date d'achèvement de la recherche | Examinateur |
|---|---|---|
| LA HAYE | 8 décembre 1998 | Segaert, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

14